# EUROPEAN PATENT APPLICATION

(11) **EP 2 390 905 A1**
(43) Date of publication of application: **30.11.2011**
(21) Application number: 10163956.5
(22) Date of filing: 26.05.2010
(51) Int. Cl.: H01L 21/66, G01N 21/59

(54) **Thin film monitoring device and method**

(71) Applicant: Applied Materials, Inc., Santa Clara, CA 95054 (US)
(72) Inventor: Witting, Karin Elisabeth, 63477, Maintal (DE); Bartella, Joachim, 63755, Alzenau (DE); Schroeder, Jürgen, 63538, Großkrotzenburg (DE)
(74) Representative: Zimmermann & Partner

(57) **Abstract**

A method for determining a quality of an etched thin film (302) deposited onto a transparent substrate (301) is provided. The method includes depositing the thin film (302) onto the transparent substrate (301). Then, the thin film (302) is etched at least at portions of the transparent substrate (301). At least one transparency level (402) of the transparent substrate (301) having deposited thereon the at least partially etched thin film (302) is measured at least at one wavelength in a wavelength range from 280 nm to 340 nm. Then the quality of the etch process is evaluated on the basis of the at least one measured transparency level (402).

## Description

### TECHNICAL FIELD OF THE INVENTION

Embodiments of the present invention relate to a thin film processing device and a method for processing thin films, and in particular relate to a thin film monitoring device adapted for monitoring thin film processes carried out by a thin film processing device and adapted for determining a quality of an etched thin film deposited onto a transparent substrate. Furthermore, the present invention relates to a method for determining the quality of a thin film before and after an etch process. For example, the processed thin films can be used for solar cell production, wherein photovoltaic layers are applied at transparent substrates.

### BACKGROUND OF THE INVENTION

Thin film processing has many applications, e.g. in the microelectronics industry, for depositing photovoltaic layers onto substrates, for modifying surfaces of substrates, etc. Specifically, for the production of thin film solar cells, glass panels are coated with a transparent conductive oxide (TCO) layer, e.g., ZnAlO. After the coating process, the thin film may be treated by a wet chemical etching process.

In some cases, due to the etching process, the transparent conductive oxide layer deposited onto the transparent substrate (e.g. onto a glass panel) may be completely removed or overetched, at least at portions of the substrate such as some small regions or spots. In these regions, the substrate-thin film layer stack is damaged and may not be used for further processing. The quality of the thin transparent conductive oxide layer may be related to a quality of the etch process, e.g. based on the fact whether or not a complete removal of the thin film deposited onto the glass panel may be avoided throughout the surface of the substrate.

In other words, it is desirable to obtain a complete coverage of the transparent substrate by the thin film even after partially etching the thin film, and thus obtaining high efficiency and throughput. A thin film of high quality includes few or no overetched regions. Moreover, it is desirable to monitor a film quality of thin films deposited onto glass panels before subsequent processing steps are carried out.

### SUMMARY OF THE INVENTION

In light of the above, a method for monitoring a quality of an etch process of a thin film deposited onto a transparent substrate according to independent claim 1 is provided. Furthermore, a thin film monitoring device adapted for determining a quality of an etched thin film deposited onto a transparent substrate according to independent claim 10 is provided.

According to one embodiment, a method for determining a quality of an etch process of a thin film deposited onto a transparent substrate is provided, the method including depositing the thin film onto the transparent substrate, etching the thin film at least at portions of the substrate, measuring, at least at one wavelength in a wavelength range from 280 nm to 340 nm, at least one transparency level of the transparent substrate having deposited thereon the at least partially etched thin film, and evaluating the quality of the etch process on the basis of the at least one measured transparency level.

According to a further embodiment, a thin film monitoring device adapted for determining a quality of an etched thin film deposited onto a transparent substrate is provided, the thin film monitoring device including a light source adapted for emitting optical radiation having at least one wavelength in a wavelength range from 280 nm to 340 nm and being incident onto the etched thin film deposited onto transparent substrate, a light detector adapted for receiving optical radiation transmitted through the transparent substrate with the thin film deposited thereon, and an evaluation unit adapted for evaluating at least one transparency level of optical radiation transmitted through the transparent substrate with the thin film deposited thereon and for evaluating the quality of the etched film on the basis of the at least one evaluated transparency level.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Figure 1: shows a schematic side sectional view of a substrate-film stack including a transparent substrate and a thin film deposited onto the transparent substrate;
- Figure 2: is a schematic side sectional view of the substrate-film stack illustrated in Fig. 1, wherein the thin film includes overetched regions;
- Figure 3: is a schematic block diagram of a thin film monitoring device adapted for determining a quality of an etched thin film deposited onto the transparent substrate, wherein transparency measurements at the substrate-film stack are indicated;
- Figure 4: is a thin film monitoring device according to another typical embodiment;
- Figure 5: is a thin film monitoring device according to yet another typical embodiment;
- Figure 6: is a block diagram of a thin film monitoring device wherein a transparency measurement of a transparent substrate without having a thin film deposited thereon is indicated;
- Figure 7: is a graph indicating measured transparency levels as a function of a wavelength of light incident onto the substrate and/or the substrate-film stack;
- Figure 8: is a schematic block diagram of a substrate processing apparatus including two thin film monitoring devices, according to yet another typical embodiment; and
- Figure 9: is a schematic flowchart illustrating a method for determining a quality of an etched film deposited onto a transparent substrate.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a method for determining a quality of an etched film deposited onto a transparent substrate, and a thin film monitoring device adapted for determining thin film quality. In particular, embodiments described herein refer inter alia to a method for determining, during an etch process, a quality of a thin film deposited onto a transparent substrate, and a measurement device for carrying out the method. The transparent substrate may be made from glass material having a specified transparency, e.g. the transparency of a glass substrate may vary from approximately 10 % to approximately 85 % in a wavelength range from 280 nm to 340 nm. Furthermore the transparency of the glass substrate may vary from approximately 50 % to approximately 80 % in a wavelength range from 310 nm to 330 nm. The glass substrate (or glass panel) may be coated with a transparent conductive oxide (TCO) layer, e.g. ZnAlO. After the coating process, the thin film is treated e.g. by a wet chemical etching process. The quality of the coating after the subsequent etch process may be determined by performing transparency measurements at the coated glass substrate. It is noted here that prior to depositing and etching the TCO layer the transparent substrate may be coated with another transparent layer such as, but not restricted to, a buffer layer, a barrier layer, a seed layer, etc. Thus, the term "transparent substrate" as used herein may include a stack of a transparent substrate and at least another transparent layer such as a barrier layer deposited onto the transparent substrate. According to the present application the transparency level is measured in relative units (%) indicating the portion of light intensity transmitted through the thin film-substrate stack compared to the light intensity incident onto the stack. Using a specific wavelength in the wavelength range from 280 nm to 340 nm an indication of the quality of the etching process may be provided by measuring the transparency level. The transparency level may vary in accordance with the transmittance of the thin film (coating) after the etch process, e.g. the wet chemical etching process. This film transmittance in turn is related to size and number of spots or holes etched through the thin film. It is to be noted that the transparent conductive (TCO) layer the quality of which is determined does not exhibit any light transmission in the spectral ranges mentioned above. Thus, a transparency level larger than zero determined by measuring an intensity of light shining through the substrate-TCO layer stack results from the above mentioned spots or holes etched through the thin film. Accordingly the quality of the thin film may be related to the size and number of etch holes (etch spots) which are not desired after the etching process has been completed. The determination of a film quality may also be related to an etch uniformity during etching the thin film which has been deposited onto the transparent substrate.

The term "film quality" as it is used herein may indicate the amount of over-etched regions or etch holes (etch spots). For example, a thin film of high quality has no or very few etch holes such that the thin film completely covers the glass substrate. In this case the transparency level of the glass substrate-thin film stack is reduced to a very low value. A complete coverage of the transparent substrate with a thin film having no etch holes at all may reduce the transparency level to zero %. Any occurrence of etch holes then increases the transparency level to values larger than zero, e.g. 0.5%, 1%, 2 % or 3%. It may be determined by an operator whether a thin film having the above mentioned transparency level has a film quality which is sufficient for further processing. The variation in transparency level may be measured and may be used for the determination of the film quality. Using the transparency level measurements mentioned above it is thus possible to evaluate the quality of a thin film-substrate stack without cutting the stack into small pieces, e.g. for microscopy inspection. It is thus possible to provide an easy and efficient means for evaluating the quality of a thin film deposited onto a glass substrate prior to performing subsequent processing steps.

Furthermore, the thin film monitoring method may be based on a comparison of transparency measurements with and without thin film deposited onto the transparent substrate. An uncoated transparent substrate is assumed to exhibit at least partial optical transparency in a wavelength range from approximately 280 nm to 340 nm. This applies for glass substrates used in solar applications (Optiwhite, etc.). A reference transparency level of the transparent substrate is measured before depositing the thin film onto the transparent substrate. After depositing the thin film onto the transparent substrate, the thin film is etched, at least partially, at at least portions of the substrate. Then, a transparency level of the transparent substrate-film stack is measured.

After a comparison of the transparency level with the reference transparency level at at least one wavelength in a measurement wavelength range, a film quality of the transparent thin film deposited onto the transparent substrate may be evaluated on the basis of this comparison. Albeit the embodiments described in the following are related to transparent conductive oxide films or layers (TCO film or layers), it is noted here that the layers are not restricted to a specific material or material composition for the thin film deposited onto a transparent substrate.

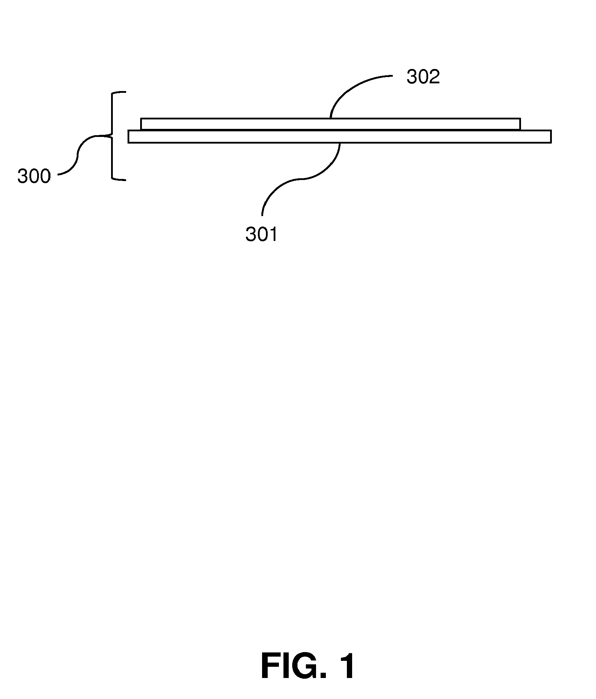

Fig. 1 is a side sectional view of a substrate-film stack 300 including a transparent substrate 301 and a thin film 302 deposited thereon. The thin film 302 may include materials such as ZnAlO, ZnO, SnO₂, CdO, etc., or any combination thereof. The substrate 301 may be a transparent glass panel, e.g., made from glass used in solar applications such as "Optiwhite", etc. In Fig. 1 it is shown that the thin film 302 which has been deposited onto the transparent substrate 301 in order to form the substrate-thin film stack 300 has been etched uniformly, i.e., no overetching occurs.

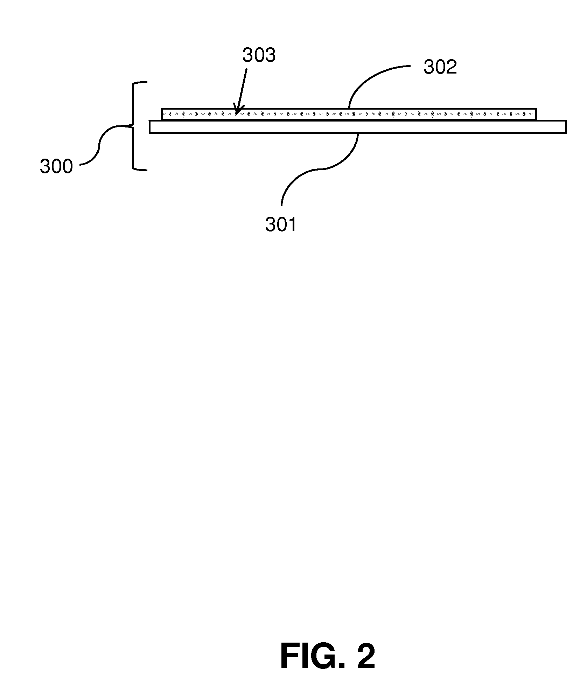

Fig. 2 shows another substrate-film stack in accordance with the film stack 300 shown in Fig. 1, wherein at least at portions of the thin film 302 deposited onto the transparent substrate 301, an overetching has occurred such that overetched regions 303 have been formed. In these overetched regions, the thin film 302 may be completely removed, or may be removed at least within small spots 303. These overetched regions should be avoided, because e.g. a solar cell including these overetched regions 303 is regarded as damaged. In other words, a substrate-thin film stack 300 including a thin film 302 having such overetched regions 303 may not be used for further processing.

It is noted here that the overetched regions may be very tiny structures, which means that the drawing of Fig. 2 may not be to scale. A presence of overetched regions 303 may be conventionally detected, e.g. by means of a SEM (scanning electron microscope) measurement device after processing. The number of overetched regions 303 may depend on an etch rate during etching the thin film 302 deposited onto the transparent substrate 301. An on-line detection of overetched regions 303, however, is not possible by means of SEM measurements.

Evaluating a film quality and/or a quality of an etch process may include evaluating an etch uniformity during etching the thin film 302 deposited onto the transparent substrate 301. The term "film quality" as it is used herein is meant to indicate the presence or absence of overetched regions 303. As can be seen from a comparison of Figs. 1 and 2, an absorbance of the substrate-thin film stack 300 may be obtained by determining transparency levels when shining light radiation through the substrate-thin film stack 300. In order to determine a film quality, an absorbance of the etched thin film 302 deposited onto the transparent substrate 301 may be evaluated.

Transmission measurements can be carried out without cutting a substrate-thin film stack 300 into small pieces which would be the case if using microscopy inspection (e.g. SEM inspection). Thus, a scan of a complete transparent substrate (glass panel) coated with a transparent conductive oxide layer (TCO layer) may be made efficiently and in a short time without damaging the transparent substrate 301 and/or the transparent conductive oxide layer 302.

It is noted here that the term "overetching" indicates a complete removal of the thin film 302 at a specific region (overetched spot). Typical areas of overetched spots are in the range of 0.5 µm² to 5 µm², and typically amount to 1 µm². A density of all overetched spots may reach up to 10% of the complete glass panel area.

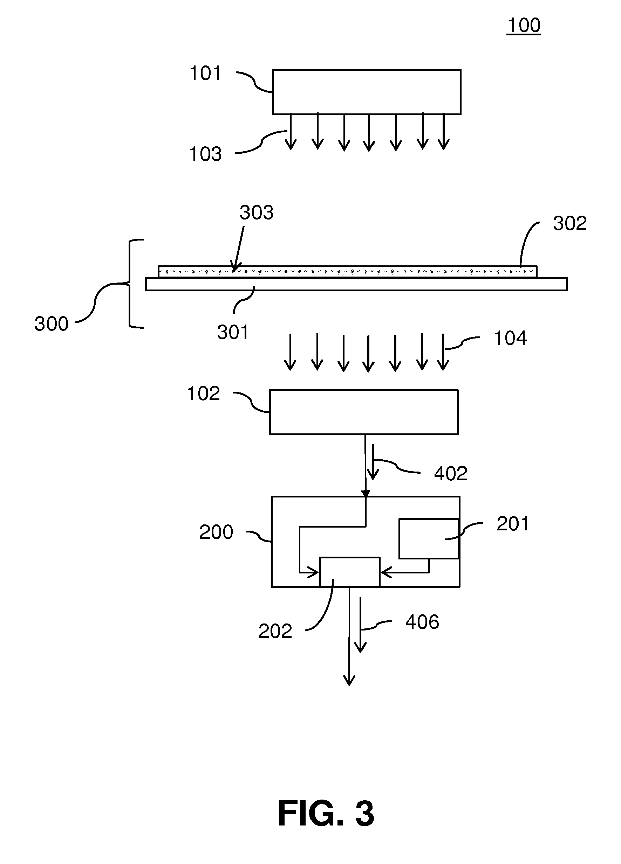

Fig. 3 is a schematic block diagram illustrating a thin film monitoring device 100 according to a first aspect. Using the thin film monitoring device 100 shown in Fig. 3 is the quality of an etch process may be evaluated. As shown in Fig. 3, a substrate-thin film stack 300 including the transparent substrate 301 and the thin film 302 deposited onto the transparent substrate 301, is monitored. In the situation shown in Fig. 3, the transparent thin film 302 has overetched regions indicated by a dash-dot line 303 in Fig. 3. The substrate-film stack 300 is illuminated by a primary radiation 103 emitted from a light source 101.

Secondary radiation 104, which is a portion of primary radiation 103 transmitted through the substrate-thin film stack 300, is detected by a light detector 102. An output signal of the light detector 102 is indicated as a transparency level 402 Light radiation is absorbed by the thin film 302 deposited onto the transparent substrate 301. A thin film 302 having no overetched regions 303 exhibits a high absorption, wherein overetched regions 303 within the thin film 302 deposited onto the transparent substrate 301 lower the absorbance within the thin film 302. Thus, the transparency level 402 depends on the overall transmittance of the substrate-thin film stack 300 and thus may be an indication of a number of overetched regions 303 within the thin film 302.

The output signal of the light detector 102, i.e. the transparency level 402 (Fig. 3) is then fed to the evaluation unit 200. The evaluation unit 200 may output a determination signal 406, which is a measure of the transparency level 402 obtained from a transparency measurement of the entire substrate-thin film stack 300, including the transparent substrate 301 having deposited thereon the thin film 302.

The light detector 102 is thus adapted for receiving optical radiation transmitted though the transparent substrate 301 with the thin film 302 deposited thereon. The evaluation unit 200 may evaluate the at least one transparency level 402 of optical radiation transmitted through the transparent substrate 301 with the thin film 302 deposited thereon. The evaluation unit 200 may then evaluate the film quality (e.g. the number and/or size of overetched regions 303 within the thin film 302) on the basis of the at least one measured transparency level.

Using the thin film monitoring device 100 shown in Fig. 3, a quality of an etch process of a thin film 302 deposited onto the transparent substrate 301 may be determined by performing the following steps: (i) depositing the thin film 302 onto the transparent substrate 301, (ii) etching the thin film 302 at least at portions of the transparent substrate 301, (iii) measuring, at least at one wavelength in a wavelength range from 280 nm to 340 nm, at least one transparency level 402 of the transparent substrate 301 having deposited thereon the at least partially etched thin film 302, and (iv) evaluating the quality of the etch process on the basis of the at least one measured transparency level.

According to yet another typical embodiment, the quality of the thin film 302 deposited onto the transparent substrate 301 may be measured by storing a reference transparency level 401 of the transparent substrate 301, which does not change during a deposition process, in a memory unit 201 of the evaluation unit 200 prior to measuring the transmittance of the substrate-thin film stack 300. After having measured the reference transparency level 401 of the transparent substrate 301, etching and/or deposition processes may be monitored during further processing steps. Thus the at least one transparency level 402 may be measured during deposition and etching processes of the substrate-thin film stack 300. Then the actually measured transparency level 402 is compared to the stored reference transparency level 401 by means of the comparator 202 provided in the evaluation unit 200.

The output signal of the comparator 202, i.e. the determination signal 406, may thus be used for evaluating the thin film quality by evaluating a difference of two transparency levels 401, 402 which reflects the amount of overetched regions 303 of the thin film 302 on the transparent substrate 301. The advantage of this procedure is the possibility of on-line measurements of the substrate-thin film stack 300 if the reference transparency level 401 of the glass plate (transparent substrate) 301 does not change during processing. In many cases, it is possible to assume that the transparency level 401 remains at a constant level during a batch process such that the transparency level 402 measured at the substrate-thin film stack 300 may be used as an output signal for determining film quality.

As already indicated herein, the term "film quality" refers to the number of over-etched regions 303. The reference transparency level 401 may correspond to the absorbance of the transparent substrate 301, wherein at the transparency level 402 may correspond to the absorbance of the substrate-thin film stack 300. If the absorbance of the transparent substrate 301 remains constant during a specific deposition/etching process, a light transmittance of the thin film 302 may be used as a measure of thin film quality. If the thin film 302 has less over-etched regions, the absorbance may increase, whereas, if the thin film 302 has a large number of overetched regions, the transparency level of the thin film, i.e., the transparency level 402 increases due to reduced absorption in the thin film 302.

According a typical embodiment which can be combined with other embodiments described herein, more than one transparency level 402 may be measured. At least two measured transparency levels 402 may be compared with a reference transparency level which may be the measured reference transparency level 401. The measured reference transparency level 401 related to the light transmittance of the transparent substrate 301 alone may be stored in the memory unit 201 of the evaluation unit 200, as described herein. Thus, the reference transparency level 401 which is stored in the memory unit 201 may be used for comparison with the at least one transparency level 402 measured at different substrate-film stacks 300. The memory unit 201 is adapted for storing the reference transparency level 401 given for a specific transparent substrate 301 and used for a comparison with the at least one transparency level 402 measured at the substrate-thin film stack 300.

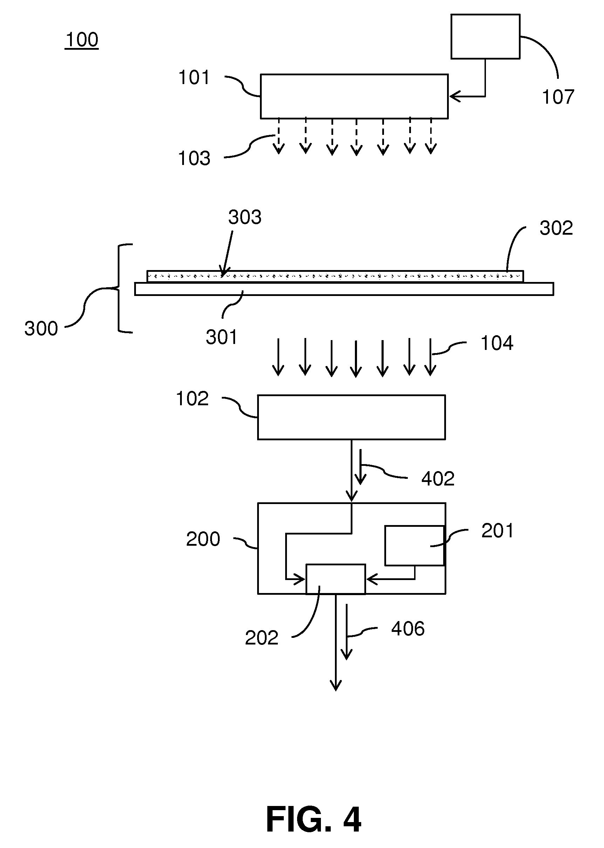

Fig. 4 is a schematic block diagram of a thin film monitoring device 100 according to yet another typical embodiment. The thin film monitoring device 100 shown in Fig. 4 has a light source 101 which is capable for varying its output wavelength. A wavelength modifying unit 107 generates primary radiation 103 of a specific wavelength which may be varied, as indicated in Fig. 4 by dashed arrows.

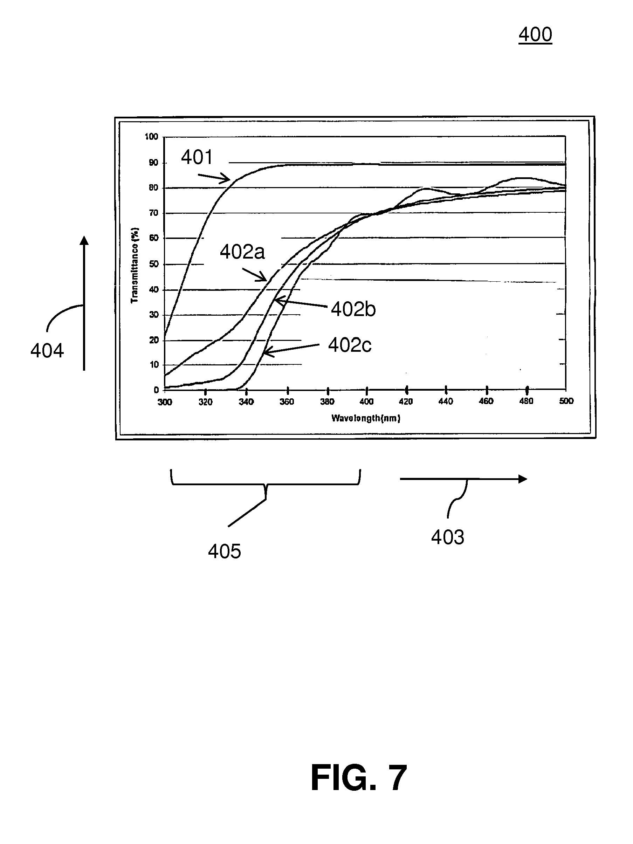

If the wavelength of the primary radiation 103 may be varied by means of the device shown in Fig. 4, a wavelength range of interest 405 (see Fig. 7) may be checked with respect to a difference of at least one transparency level 402 with respect to the reference transparency level 401, as will be described herein below. The light detector 102 is adapted for receiving a broad range of wavelengths, i.e. for receiving at least a wavelength range which is emitted by the light detector 101. It is noted here that components which have already been described with reference to Figs. 1 to 3 are not described again in order to avoid a redundant description.

The light source 101 may be designed as a laser light source, the output wavelength of which may varied in a specific wavelength range. The measured transparency levels 401, 402 are then given as a function of wavelength, i.e. a wavelength distribution curve is detected. For example, during measuring the transparency levels 401, 402, a wavelength of the light source 101 emitting optical radiation incident onto the transparent substrate 301 and the substrate-thin film stack 300 may be varied in a wavelength range from 270 nm to 400 nm, and more preferably in a wavelength range from 280 nm to 340 nm.

According to yet other typical embodiments, which can be combined with other embodiments described herein, a light source that emits a broad wavelength range can be provided. Further, a detection unit for detecting the transmitted light might then include a spectrometer or the like in order to evaluate the transmitted light depending on the wavelength.

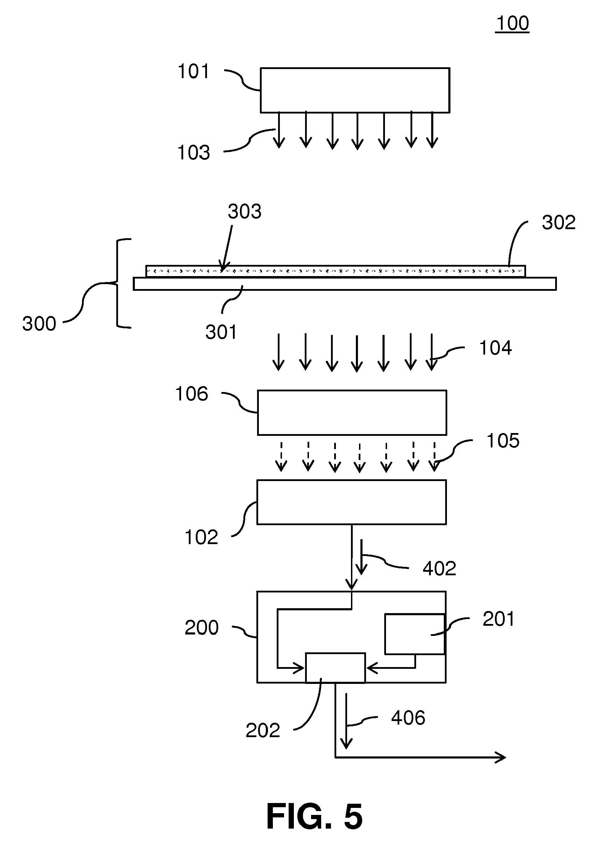

Fig. 5 is a schematic block diagram of a thin film monitoring device 100 according to yet another typical embodiment. The thin film monitoring device 100 shown in Fig. 5 includes a spectroscopic unit 106 used for filtering a specific wavelength included in the secondary radiation 104 obtained after transmitting the primary radiation 103 through the substrate-thin film stack 300. It is noted here that components which have been described already with reference to Figs. 1 to 4 are not described here in order to avoid a redundant description. The light source 101 may emit a broad wavelength spectrum.

In order to obtain a wavelength resolution, the spectroscopic unit 106 disperses a wavelength range of the secondary radiation or filters out a portion of the secondary radiation 104 such that a filtered radiation 105 at a specific wavelength and/or in a narrow wavelength band is obtained. The filtered radiation 105 is then incident onto the light detector 102 which is sensitive for optical radiation in a broad wavelength spectrum. The measured transparency levels 401, 402 are obtained as a function of wavelength.

Typically, depending on the light source 101, which is used for measuring the different transparency levels, the transparency levels can be corrected by the emission characteristics of the light source. However, in the case where a comparison of transparency levels is conducted, e.g. by dividing one transparency level by another transparency level, the comparison might be conducted independently from the light source emission wavelength characteristics because the emission characteristics do not influence this kind of comparison.

Thus, it is possible to compare the transparency level 402 with the reference transparency level 401 in a specific wavelength range and/or at one specific wavelength. Thus, a detection wavelength of the light detector 102 may be varied in order to receive an optical radiation transmitted through the transparent substrate 301 and/or the substrate-thin film stack 300 in a wavelength range from 270 nm to 400 nm, and more preferably in a wavelength range from 280 nm to 340 nm. The spectroscopic unit 106 may thus be provided as a filter unit adapted for optically filtering a narrow wavelength range out of the wavelength range of the optical radiation 104 transmitted through the substrate 301 and/or the substrate-thin film stack 300.

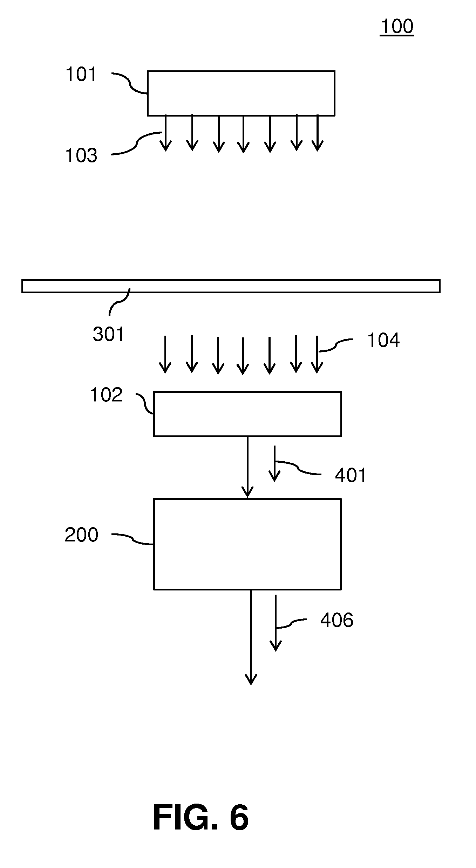

Fig. 6 is a schematic block diagram of a thin film monitoring device 100 according to yet another typical embodiment which can be combined with other embodiments described herein. The thin film monitoring device 100 shown in Fig. 6 is adapted for determining a quality of an etched thin film 302 by first measuring a transmittance of the glass substrate 301 alone. In Fig. 6, it is indicated that a transparency level 401 of the transparent substrate 301 may be measured by transmitting primary radiation 103 (primary light) emitted from a light source 101 through the uncoated transparent substrate 301.

A portion of the primary radiation 103 which is not absorbed or reflected by the transparent substrate 301 is transmitted through the transparent substrate 301 and is incident, as a secondary radiation 104, onto a light detector 102. The light detector 102 is designed to measure a light intensity and to convert the measured light intensity into the reference transparency level 401. The reference transparency level 401 which may be an electrical output signal of the light detector 102 is fed to an evaluation unit 200 which evaluates, on the basis of the reference transparency level 401, a transmittance of the transparent substrate 301. Thus the evaluation unit 200 may output a determination signal 406 indicating a transmittance of the uncoated transparent substrate 301.

It is noted here that the primary and secondary radiations 103, 104, which are referred to as optical radiation, may include ultraviolet radiation, visible radiation and infrared radiation, e.g., the spectral region of UV, VIS, and IR is encompassed by the term "optical radiation". More typically, according to another embodiment with can be combined with embodiments described herein, the wavelength region covered by the primary and secondary radiations 103, 104 includes spectral regions of ultraviolet and visible radiation (UV - VIS). Albeit not mentioned in the drawings, the light source 101 may include optics, such as focusing optics, in order to illuminate a predetermined area of the transparent substrate 301. According to a typical embodiment the light detector 102 may be provided as a photodiode, a line array detector, or a two-dimensional detector in order to monitor regions of interest of the transparent substrate 301. Measuring at least one transparency level 402 of the transparent substrate 301 having deposited thereon the at least partially etched thin film 301 may include measuring the transparency level 402 at the substrate 301 having the same area as the area during deposition of the thin film. According to yet typical embodiments, which can be combined with other embodiments described herein, a detection unit for detecting the transmitted light might particularly include a spectrometer or the like in order to evaluate the transmitted light depending on the wavelength.

Fig. 7 is a graph showing measured optical transmittances 404 as a function of wavelength 403. The wavelength range indicated in Fig. 7 extends from approximately 300 nm to approximately 500 nm. The measurable wavelength range, however, is not restricted to the range shown in Fig. 7. Furthermore, a wavelength range of interest 405 is indicated. This wavelength range 405 is relvant for measuring transparent glass substrates coated by TCO layers. In this wavelength range 405, a large difference in transmittance between the different transparency levels 402 and the reference transparency level 401 may be obtained. A curve 401 indicates the reference transparency level measured at the transparent substrate 301 alone (see Figs. 1 and 6).

The curves 402a, 402b, and 402c are transparency levels which have been measured at a substrate-thin film stack 300 (see Figs. 1 to 5). As shown in the graphs of Fig. 7, it is clearly indicated that, in the wavelength range of interest 405, a large difference in transmittance between the reference transparency level 401 and the transparency levels 402a, 402b, and 402c, respectively, is obtained.

A typical measurement range is from 270 nm to 400 nm, more preferably the measurements are carried out in a wavelength range from 280 nm to 340 nm, and even more preferably at a wavelength of approximately 320 nm. In the following, the curves indicated in the graph of Fig. 7 are exemplarily discussed with respect to a wavelength of 320 nm. It can be seen from the curves shown in the graph of Fig. 7 that the transmittance of the uncoated sample, i.e., the transmittance of the transparent substrate 301 without thin film 302 deposited thereon amounts to approximately 70%, as indicated by the reference transparency level 401. The uncoated sample used for the measurement shown in Fig. 7, curve 404, was Corning glass.

Three etched substrate-film stacks 300 having different overetched regions resulting in three different transparency levels 402a, 402b, and 402c are compared with the reference transparency level 401 of the uncoated sample (glass substrate). An etched sample having no overetched regions results in a transparency level 402c, which corresponds to a thin film of high quality. As shown in Fig. 7, the transparency level at this specific wavelength of 320 nm amounts to approximately 0%.

The next sample, i.e. a substrate-thin film stack 300 including a thin film 302 with some overetched regions 303, results in a transparency level 402b of 3% at the wavelength of 320 nm indicating a thin film of medium quality. A third sample resulting in a transparency level 402a includes numerous overetched regions 303 within the thin film 302, i.e. numerous transparent spots, which results in a transparency level 402a of 17% at the wavelength of 320 nm. The measurement result of the third sample thus indicates a thin film 302 of poor quality. Thus, a correlation between optical transmittance and overetched regions 303 (overetched area) can be obtained.

It is noted here that for a different measurement wavelength, other values of transmittance and/or transmittance differences are obtained. A difference in transmittance, however, is obtained in any case, if a different number of overetched regions 303 (overetched areas, number of etched spots) are present.

Furthermore, it is possible to distinguish the individual samples having different numbers of overetched regions 303 by means of the shape of the respective transparency curves 402a, 402b, 402c. The thin film monitoring devices 100 according to typical embodiments shown in Figs. 4 and 5 may vary the wavelength at which the respective transparency levels are measured. By detecting the transmittance signal as a function of the wavelength, it is thus possible to obtain the shape of the transmittance curves of the individual samples. From the obtained shape, a specific transmittance curve may be identified, and thus a thin film quality of the respective thin film 302 may be evaluated.

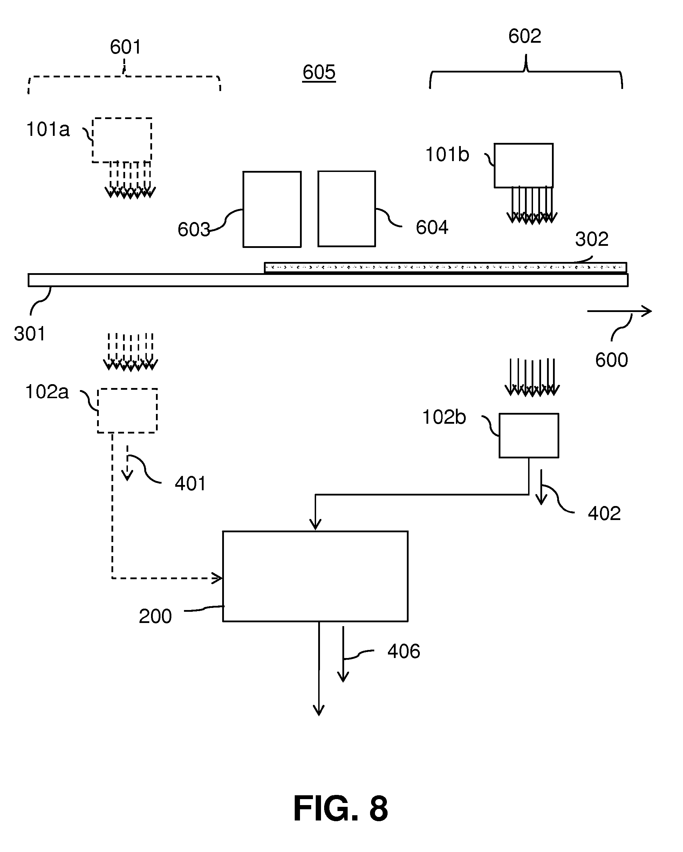

Fig. 8 is a schematic block diagram of a substrate processing apparatus 605 including two thin film monitoring devices, i.e., a first thin film monitoring device 601 and a second thin film monitoring device 602, according to yet another typical embodiment. The first thin film monitoring device 601 may be provided as an option for the determination of a transparency level of the transparent substrate 301 without thin film 302 deposited thereon. This option is indicated by broken lines in Fig. 8. The substrate processing apparatus 605 is adapted for processing the transparent substrate 301 and includes the first monitoring device 601 which is adapted for measuring the reference transparency level 401 of optical radiation transmitted through the transparent substrate 301 alone, a thin film deposition device 603 adapted for depositing the thin film 302 onto the transparent substrate 301, an etching device 604 adapted for etching, at least partially, the thin film 302 deposited onto the transparent substrate 301, a second monitoring device 602 adapted for measuring at least one transparency level 402 of optical radiation transmitted through the transparent substrate 301 with the thin film 302 deposited thereon, and the evaluation unit 200 adapted for comparing the transparency level 402 with the reference transparency level 401 and for evaluating the film quality on the basis of the comparison.

The first monitoring device 601 may include a first light source 101a adapted for emitting optical radiation incident onto the transparent substrate 301 and a first light detector 102a adapted for receiving optical radiation transmitted through the transparent substrate 301 and for outputting a first signal indicating the reference transparency level 401. On the other hand, the second monitoring device 602 may include a second light source 101b adapted for emitting optical radiation incident onto the transparent substrate 301 having deposited the partially etched thin film 302 thereon and a second light detector 102b adapted for receiving optical radiation transmitted through the transparent substrate 301 having deposited the partially etched thin film 402 thereon and for outputting a second signal indicating the transparency level 402. It is assumed here that the substrate 301 is transported in a processing direction 600. Thus the first monitoring device 601 only measures the transparent substrate 301 alone, wherein the second monitoring device 602 measures the substrate 301 with the thin film 302 deposited thereon. A quality of the thin film 302 deposited by means of the deposition device 603 and partially etched by means of the etching device 604 may thus be evaluated by comparing the output signals 401, 402 of the two monitoring devices 601 and 602, respectively.

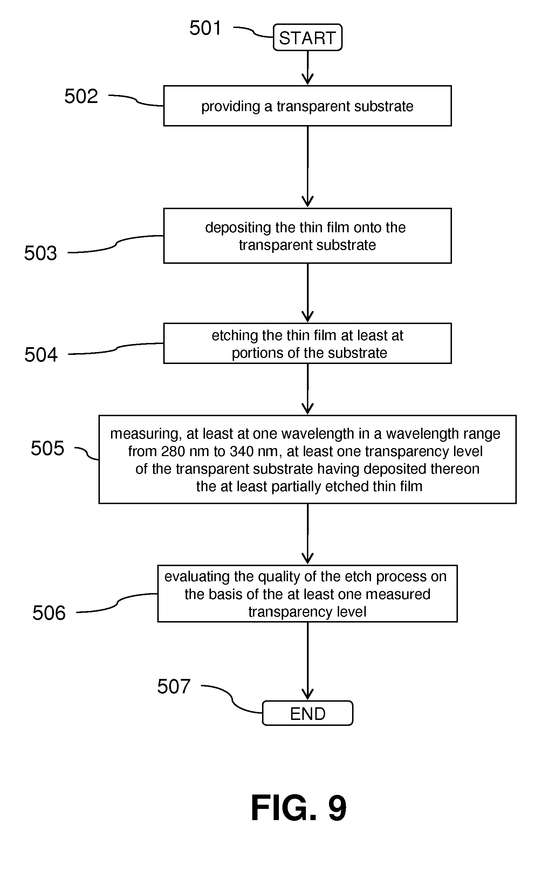

Fig. 9 is a flowchart illustrating a method for determining the quality of an etched thin film which has been deposited onto a transparent substrate 301. At a block 501 the process is started. At a block 502 a transparent substrate 301 is provided. The thin film 302 is deposited onto the transparent substrate 301 (block 503). At a block 504 the thin film is etched at least at portions of the transparent substrate 301.

At a block 505 at least one transparency level 402, 402a-402c of the transparent substrate 301 is measured at least at one wavelength in a wavelength range from 270 nm to 400 nm, and more preferably in a wavelength range from 280 nm to 340 nm, wherein the transparent substrate 301 having deposited thereon the at least partially etched thin film 302 has been etched in block 504. A quality of the etch process may then be evaluated on the basis of the at least one measured transparency level (block 506).

The measurement of the at least one transparency level may be performed in a specific wavelength range of interest 405, or at a single wavelength. Furthermore, the shape of the respective transparency curves may be determined by varying the wavelength of the optical radiation transmitted through the substrate-thin film stack 300. The procedure is ended at a block 507.

In light of the above, a plurality of embodiments have been described. For example, according to one embodiment, a method is provided for determining a quality of an etch process of a thin film deposited onto a transparent substrate, the method including depositing the thin film onto the transparent substrate, etching the thin film at least at portions of the substrate, measuring, at least at one wavelength in a wavelength range from 280 nm to 340 nm, at least one transparency level of the transparent substrate having deposited thereon the at least partially etched thin film, and evaluating the quality of the etch process on the basis of the at least one measured transparency level. According to an optional modification thereof measuring the transparency level includes measuring the transparency level at the substrate having the same area as the area during deposition. Furthermore, the measured transparency level may be compared with a reference transparency level measured at the transparent substrate without applied thin film. According to yet further embodiments, which can be combined with any of the other embodiments and modifications above, an absorbance of the substrate-thin film stack may be determined by comparing the transparency level with the reference transparency level. The reference transparency level may be stored in a memory unit and may be used for comparison with transparency levels measured at at least two different substrate-film stacks. During measuring the transparency level, a wavelength of a light source emitting optical radiation incident onto the substrate may be varied in a wavelength range from 280 nm to 340 nm. In addition to that, or alternatively, during measuring the transparency level, a detection wavelength of a light detector selectively receiving optical radiation transmitted through the substrate may be varied in a wavelength range from 280 nm to 340 nm. Evaluating the film quality may include evaluating an etch rate during etching the thin film deposited onto the transparent substrate. According to yet further additional or alternative modifications evaluating the film quality may include evaluating an absorbance of the etched film deposited onto the transparent substrate. According to another embodiment a thin film monitoring device adapted for determining a quality of an etched thin film deposited onto a transparent substrate is provided, the thin film monitoring device including a light source adapted for emitting optical radiation having at least at one wavelength in a wavelength range from 280 nm to 340 nm and being incident onto the etched thin film deposited onto transparent substrate, a light detector adapted for receiving optical radiation transmitted through the transparent substrate with the thin film deposited thereon, and an evaluation unit adapted for evaluating at least one transparency level of optical radiation transmitted through the transparent substrate with the thin film deposited thereon and for evaluating the quality of the etched film on the basis of the at least one evaluated transparency level. According to yet further embodiments, which can be combined with any of the other embodiments and modifications above, the light source is adapted for transmitting optical radiation through the substrate having the same area as the area of the deposited thin film. Furthermore, the light detector may be adapted for receiving optical radiation transmitted through the substrate having the same area as the area of the deposited thin film. According to an optional modification thereof the light source adapted for emitting optical radiation incident onto the transparent substrate is provided as a laser. Moreover a memory unit adapted for storing a reference transparency level measured at the transparent substrate without applied thin film and used for comparison with the transparency level may be provided. According to yet further embodiments, which can be combined with any of the other embodiments and modifications above, a wavelength scanning unit adapted for varying the wavelength of the optical radiation transmitted through the transparent substrate with the thin film deposited thereon in the wavelength range from 280 nm to 340 nm may be provided.

While the foregoing is directed to embodiments of the invention, other and further embodiments of the invention may be devised without departing from the basic scope thereof, and the scope thereof is determined by the claims that follow.

### Reference numerals

| **No.** | **Part** |
|---|---|
| 100 | thin film monitoring device |
| 101 | light source |
| 102 | light detector |
| 103 | primary radiation |
| 104 | secondary radiation |
| 105 | filtered radiation |
| 106 | spectroscopic unit |
| 107 | wavelength modifying unit |
| 200 | evaluation unit |
| 201 | memory unit |
| 202 | comparator |
| 300 | substrate-thin film stack |
| 301 | transparent substrate |
| 302 | thin film |
| 303 | overetched region |
| 400 | measurement result graph |
| 401 | reference transparency level |
| 402 | transparency level |
| 403 | wavelength |
| 404 | transmittance |
| 405 | wavelength range of interest |

## Claims

1. A method for determining a quality of an etch process of a thin film deposited onto a transparent substrate, the method comprising:
depositing the thin film onto the transparent substrate;
etching the thin film at least at portions of the substrate;
measuring, at least at one wavelength in a wavelength range from 280 nm to 340 nm, at least one transparency level of the transparent substrate having deposited thereon the at least partially etched thin film; and
evaluating the quality of the etch process on the basis of the at least one measured transparency level.

2. The method in accordance with claim 1, wherein measuring the transparency level comprises measuring the transparency level at the substrate having the same area as the area during deposition.

3. The method in accordance with claim 1 or 2, wherein the measured transparency level is compared with a reference transparency level measured at the transparent substrate without applied thin film.

4. The method in accordance with claim 3, wherein an absorbance of a substrate-thin film stack is determined by comparing the transparency level with the reference transparency level.

5. The method in accordance with claim 3 or 4, wherein the reference transparency level is stored in a memory unit and is used for comparison with transparency levels measured at least at two different substrate-film stacks.

6. The method in accordance with any one of the preceding claims, wherein, during measuring the transparency level, a wavelength of a light source emitting optical radiation incident onto the substrate is varied in a wavelength range from 270 nm to 400 nm, and more preferably in a wavelength range from 280 nm to 340 nm.

7. The method in accordance with any one of the preceding claims, wherein, during measuring the transparency level, a detection wavelength of a light detector selectively receiving optical radiation transmitted through the substrate is varied in a wavelength range from 270 nm to 400 nm, and more preferably in a wavelength range from 280 nm to 340 nm.

8. The method in accordance with any one of the preceding claims, wherein evaluating the film quality comprises evaluating an etch rate during etching the thin film deposited onto the transparent substrate.

9. The method in accordance with any one of the preceding claims, wherein evaluating the film quality comprises evaluating an absorbance of the etched film deposited onto the transparent substrate.

10. A thin film monitoring device adapted for determining a quality of an etched thin film deposited onto a transparent substrate, the thin film monitoring device comprising:
a light source adapted for emitting optical radiation having at least one wavelength in a wavelength range from 280 nm to 340 nm and being incident onto the etched thin film deposited onto transparent substrate;
a light detector adapted for receiving optical radiation transmitted through the transparent substrate with the thin film deposited thereon; and
an evaluation unit adapted for evaluating at least one transparency level of optical radiation transmitted through the transparent substrate with the thin film deposited thereon and for evaluating the quality of the etched film on the basis of the at least one evaluated transparency level.

11. The thin film monitoring device in accordance with claim 10, wherein the light source is adapted for transmitting optical radiation through the substrate having the same area as the area of the deposited thin film.

12. The thin film monitoring device in accordance with claim 10 or 11, wherein the light detector is adapted for receiving optical radiation transmitted through the substrate having the same area as the area of the deposited thin film.

13. The thin film monitoring device in accordance with any one of the claims 10 to 12, wherein the light source adapted for emitting optical radiation incident onto the transparent substrate is provided as a laser.

14. The thin film monitoring device in accordance with any one of the claims 10 to 13, further comprising a memory unit adapted for storing a reference transparency level measured at the transparent substrate without applied thin film and used for comparison with the transparency level.

15. The thin film monitoring device in accordance with any one of the claims 10 to 14, further comprising a wavelength scanning unit adapted for varying the wavelength of the optical radiation transmitted through the transparent substrate with the thin film deposited thereon, in the wavelength range from 280 nm to 340 nm.
